# EUROPÄISCHE PATENTSCHRIFT

(11) **EP 3 127 200 B1**
(45) Veröffentlichungstag und Bekanntmachung des Hinweises auf die Patenterteilung: **05.08.2020**
(21) Anmeldenummer: 15713741.5
(22) Anmeldetag: 31.03.2015
(51) Int. Cl.: H01R 43/00, H01R 9/26, H05K 7/14

(54) **ANLAGE UND VERFAHREN ZUR AUFTRAGSINDIVIDUELLEN BESTÜCKUNG VON TRAGSCHIENEN MIT BAUTEILEN, UND BESTÜCKTE TRAGSCHIENE UNTER VERWENDUNG DER ANLAGE**
SYSTEM AND METHOD FOR FITTING COMPONENTS ON CARRIER RAILS IN AN ORDER-SPECIFIC MANNER, AND CARRIER RAIL ASSEMBLY USING THE SYSTEM
INSTALLATION ET PROCÉDÉ DESTINÉS À ÉQUIPER DES RAILS DE SUPPORT D'ÉLÉMENTS DE FAÇON PERSONNALISÉE, UND RAIL DE SUPPORT ÉQUIPÉ UTILISANT L'INSTALLATION

(30) Priorität: 03.04.2014 DE 102014104728
(43) Veröffentlichungstag der Anmeldung: 08.02.2017
(73) Patentinhaber: Phoenix Contact GmbH & Co. KG, 32825 Blomberg (DE)
(72) Erfinder: POSSEL-DÖLKEN, Frank, 32756 Detmold (DE); OBLOTZKI, Jörg, 32107 Bad Salzuflen (DE)
(74) Vertreter: Janke, Christiane
(86) Internationale Anmeldenummer: PCT/EP2015/057037
(87) Internationale Veröffentlichungsnummer: WO 2015/150389

(56) Entgegenhaltungen:
- WO-A1-2009/091888
- WO-A1-2010/094459
- WO-A1-2013/056850
- DE-A1- 3 929 721
- DE-A1-102010 047 369
- FR-A1- 2 951 591
- US-A1- 2007 057 789

## Beschreibung

Die Erfindung betrifft eine Anlage zur auftragsindividuellen Bestückung von Tragschienen mit Bauteilen, die für den späteren Einbau in Schaltschränke bestimmt sind. Bei den Bauteilen, mit denen die Tragschienen bestückt werden, handelt es sich insbesondere um Reihenklemmen, elektrische Geräte oder Endhalter. Darüber hinaus betrifft die Erfindung eine bestückte Tragschiene für den Einbau in Schaltschränke, die auftragsindividuell mit Bauteilen, insbesondere Reihenklemmen, elektrischen Geräten oder Endhaltern bestückt ist unter Verwendung einer Anlage zur auftragsindividuellen Bestückung von Tragschienen mit Bauteilen, sowie ein Verfahren zur auftragsindividuellen Bestückung von Tragschienen mit Bauteilen, insbesondere Reihenklemmen, elektrische Geräte oder Endhalter, die für den späteren Einbau in Schaltschränke bestimmt sind.

Eine mit Reihenklemmen als Bauteile bestückte Tragschiene ist beispielsweise aus der DE 39 29 721 A1 bekannt. Neben den Reihenklemmen sind auf der Tragschiene endseitig Endhalter angeordnet, die dazu dienen auf der Tragschiene aufgereihte Reihenklemmen stirnseitig abzustützen und gegen Verrutschen auf der Tragschiene zu sichern.

Schaltschränke, in welche die Tragschienen üblicher Weise eingebaut werden, weisen eine Vielzahl von horizontal und/oder vertikal nebeneinander angeordneten Reihen zur Aufnahme der Tragschienen auf. Dabei kann die Bestückung der Tragschienen mit den Bauteilen erst dann erfolgen, wenn die Tragschienen bereits im Schaltschrank eingebaut sind.

Ebenso ist es üblich, die Tragschienen vor dem Einbau in die Schaltschränke mit den Bauteilen auftragsindividuell zu bestücken. Dabei bedeutet auftragsindividuell, dass die Bestückung entsprechend eines individuellen Auftrags erfolgt, der festlegt, welche Bauteile (z.B. Reihenklemmen, elektrische Geräte, Endhalter), wie viele dieser Bauteile und in welcher Reihenfolge diese auf der Tragschiene anzuordnen sind. Dabei können die Auftragsdaten ggf. auch eine Information darüber enthalten, wie die einzelnen Bauteil auf der Tragschiene zu beschriften bzw. mit Beschriftungsschildern oder dergleichen zu versehen sind. Die vollständig bestückten (vorkonfektionierten) Tragschienen werden dann beim Schaltschrankbauer oder Vorort beim Betreiber des Schaltschranks, dort wo der Schaltschrank steht, in den Schaltschrank eingebaut. Da die Tragschienen auftragsindividuell bestückt wurden und somit unterschiedlich sind, hat auch die Weiterverarbeitung der bestückten Tragschiene, z.B. die Beschriftung der Bauteile, auftragsindividuell zu erfolgen. Auch der Einbau der bestückten Tragschienen in die Schaltschränke hat aufgrund der Verschiedenheit der vorbestückten Tragschienen auftragsindividuell zu erfolgen. Bei einer Falschzuordnung einer vorbestückten Tragschiene kommt es zu Fehlern in der Weiterverarbeitung und zum Einbau in einen falschen Schaltschrank oder an einer falschen Position im Schaltschrank.

Aus der DE 10 2010 047 369 A1 ist eine Anlage zur Bestückung von Tragschienen mit Bauteilen bekannt.

Aus der WO 2010/094459 A1 ist ein Montageprofil, das bereits im Schaltschrank verbaut ist.

Aus der DE 10 2010 047 369 A1 ist ein Verfahren zur Montage von Bauteilen auf einer Tragschiene sowie System zur Durchführung des Verfahrens bekannt.

Aus der US 2007 057 789 A1 ist ein Verfahren zur Überwachung von Artikeln oder Materialien aus Herstellungsprozessen bekannt.

Aufgabe der Erfindung ist es, die Weiterverarbeitung von auftragsindividuell vorbestückten Tragschienen sowie deren späteren Einbau in Schaltschränke in zuverlässiger Weise zu vereinfachen.

Diese Aufgabe wird durch eine Anlage gemäß Anspruch 1, eine bestückte Tragschiene gemäß Anspruch 9, sowie ein Verfahren gemäß Anspruch 17 gelöst. Die Unteransprüche betreffen vorteilhafte Weiterbildungen der Erfindung.

Die Anlage zur auftragsindividuellen Bestückung von Tragschienen mit Bauteilen, die für den späteren Einbau in Schaltschränke bestimmt sind, weist eine Basiszelle auf, in der mindestens eine Vorratseinheit für die Bevorratung der zu bestückenden Bauteile und mindestens eine Vorratseinheit für die Bevorratung von Tragschienen angeordnet ist, wobei in der Basiszelle die Bestückung der Tragschiene mit den Bauteilen erfolgt. Erfindungsgemäß weist die Basiszelle eine Schreibgerät auf, das dazu ausgebildet ist, drahtlos Daten jeweils an eine an der mit Bauteilen bestückten Tragschiene angeordnete Speichereinheit mit integrierter drahtloser Kommunikationsschnittstelle zur Abspeicherung zu übertragen, wobei die Daten auftragsindividuelle Informationen enthalten.

Bei den Bauteilen, mit denen die Tragschiene bestückt wird, handelt es sich insbesondere um Reihenklemmen, elektrische Geräte (z.B. Trennverstärker, Relais etc.) und Endhalter. Die Bauteile weisen entsprechende Mittel zum Aufrasten auf die Tragschiene auf. Die Tragschienen selbst sind vorzugsweise als sogenannte Hutschienen ausgebildet.

Die auftragsindividuellen Daten, welche in der an der fertig bestückten Tragschiene angeordneten Speichereinheit gespeichert sind, können in der weiteren Bearbeitung bzw. Handhabung der bestückten Tragschiene ausgelesen werden, wobei dann in einfacher Weise anhand der ausgelesen auftragsindividuellen Daten die weitere Bearbeitung in einer weiteren Zelle erfolgen kann. Auch der Einbau der bestückten Tragschienen in die Schaltschränke kann anhand der einfach auslesbaren Daten in einfacher Weise erfolgen, ohne dass in aufwendiger Weise schriftliche Auftragsbegleitdokumente erstellt und ausgewertet werden müssen.

Dadurch, dass die Speichereinheit über eine drahtlose Kommunikationsschnittstelle verfügt, können die auftragsindividuellen Daten in einfacher Weise berührungslos und auch bei Sichtbehinderung durch entsprechende drahtlos arbeitende Lesegeräte ausgelesen werden. Im Unterschied zu aufgedruckten Daten haben die erfindungsgemäß abgespeicherten und elektronisch, drahtlos wiederauslesbaren Daten den Vorteil, dass Beschädigungen, z.B. durch Abrieb, die zu einer Unleserlichkeit führen, nicht auftreten können.

In einer vorteilhaften Ausführungsform enthalten die auftragsindividuellen Daten anstatt der vollständigen Auftragsinformationen lediglich eine Auftragsnummer, wobei in einem Leitsystem der Anlage und/oder in einer lokalen Steuerung einer Weiterbearbeitungszelle Auftragsnummern und zugehörige Auftragsinformationen gespeichert sind. Die aus der Speichereinheit ausgelesene Auftragsnummer wird dann an das Leitsystem und/oder die lokale Steuerung weitergeleitet, um die zugehörigen Auftragsinformationen zu erhalten, die für die Bearbeitung in der Weiterbearbeitungszelle erforderlich sind. Das Abspeichern einer Auftragsnummer erfordert wesentlich weniger Speicherplatz als das Abspeichern umfangreicher Auftragsinformationen. Auf diese Weise kann der eigentliche Speicher der erfindungsgemäßen Speichereinheit entsprechend klein und damit kostengünstig ausgebildet sein. Darüber hinaus erfolgt das Abspeichern und Auslesen einer vergleichsweise kurzen Auftragsnummer, die nur eine geringe Datenmenge umfasst, sehr schnell, so dass es hier zu keinen nachteiligen Verzögerungen kommt.

In einer weiteren vorteilhaften Ausführungsform enthalten die auftragsindividuellen Daten zusätzlich oder alternativ zu den oben genannten Informationen eine Ortskennzeichnung zur Kennzeichnung des Schaltschranks, in den die bestückte Tragschiene einzubauen ist, wobei die Ortskennzeichnung insbesondere noch eine Information zur Einbauposition der bestückten Tragschiene innerhalb des Schaltschranks umfasst. Ein Monteur kann dann in einfacher Weise mit einem mobilen Lesegerät das Ortskennzeichnen auslesen und - ohne weitere Unterlagen zu konsultieren - die bestückte Tragschiene in den richtigen Schaltschrank und dort an der richtigen Position montieren.

Anhand der beigefügten Zeichnungen soll die Erfindung nachfolgend näher erläutert werden. Dabei zeigt:
- Fig. 1A: eine mit Bauteilen bestückte Tragschiene mit einem in einem Endhalter integrierten RFID-Transponder,
- Fig. 1B: eine mit Bauteilen bestückte Tragschiene wie in Fig. 1A, wobei der RFID-Transponder jedoch in einem Relais-Bauteil integriert ist,
- Fig. 1C: eine mit Bauteilen bestückte Tragschiene wie in Fig. 1A, wobei der RFID-Transponder jedoch in der Tragschiene selbst integriert ist.
- Fig.2: eine schematische Übersicht über die erfindungsgemäße Anlage bestehend aus einer Basiszelle und zwei nachfolgenden Zellen zur Weiterbearbeitung,
- Fig. 3: eine schematische Darstellung einer ersten Weiterbearbeitungszelle,
- Fig. 4: eine schematische Darstellung einer zweiten Weiterbearbeitungszelle,
- Fig. 5: eine schematische Darstellung einer Reihe von Schaltschränken und ein mobiles RFID-Lesegerät zum Auslesen der an der bestückten Tragschiene angeordneten Speichereinheit.

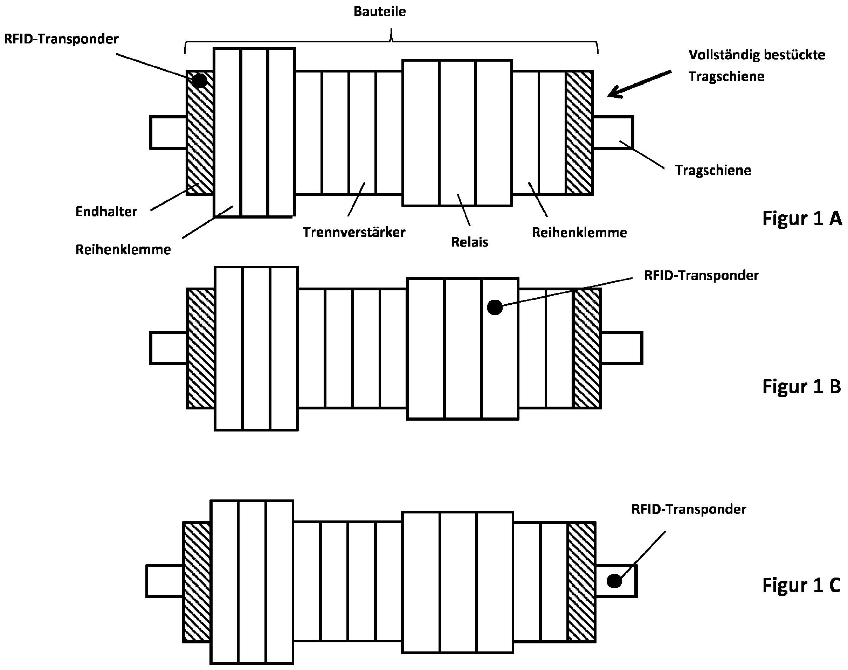

Die Figuren 1A bis 1C zeigen jeweils eine mit Bauteilen bestückte Tragschiene. Im dargestellten Beispiel handelt es sich bei den aneinandergereihten Bauteilen um Reihenklemmen, Trennverstärker und Relais. Jedes der Bauteile weist ein separates Gehäuse auf, über das das Bauteil mit entsprechenden Mitteln auf die Tragschiene aufgerastet ist. Endseitig ist jeweils ein Endhalter als abstützendes Bauteil angeordnet. Die bestückte Tragschiene weist nun eine Speichereinheit mit integrierter drahtloser, funkbasierter Kommunikationsschnittstelle auf, die zur Abspeicherung von auftragsindividuellen Daten betreffend die bestückte Tragschiene dient.

Als Speichereinheit mit integrierter drahtloser Kommunikationsschnittstelle wird vorzugsweise ein sogenannter RFID-Transponder verwendet (RFID: Radio Frequency Indentification). Als Speicher wird vorzugsweise ein nicht-flüchtiger Speicher, z.B. EEPROM, eingesetzt, da dabei die Daten auch ohne Stromversorgung gespeichert bleiben, so dass kostengünstige passive RFID-Transponder eingesetzt werden können, die keine eigene Energieversorgung haben, sondern ihre Energie aus den Funksignalen der entsprechenden Schreib-/Lesegeräte beziehen. Wenn nur eine Auftragsnummer und ein Ortskennzeichen abgespeichert wird, ist nur ein Speicherplatz von deutlich unter 1 K Bit erforderlich, was ebenfalls den Einsatz kostengünstiger RFID-Transponder ermöglicht.

Die Erfindung ist jedoch nicht auf die Verwendung von RFID-Transpondern beschränkt. Vielmehr können auch andere drahtlose Kommunikationsschnittstellen eingesetzt werden, insbesondere solche, die nach dem sogenannten NFC-Standard arbeiten (NFC: Near Field Communication). Sofern in den nachfolgend beschriebenen Ausführungsformen von einem RFID-Transponder die Rede ist, so sind diese Ausführungsformen ausdrücklich nicht auf die Verwendung von RFID-Transpondern beschränkt, vielmehr können auch in diesen Ausführungsformen Speichereinheiten mit anderen drahtlosen Kommunikationsschnittstellen eingesetzt werden.

Die Speichereinheit mit der drahtlosen Kommunikationsschnittstelle (in Fig. 1A bis 1C der RFID-Transponder) kann in einem Bauteil oder in der Tragschiene selbst integriert sein. In der Ausführungsform gemäß Fig. 1A ist der RFID-Transponder in einem Endhalter integriert. In der Ausführungsform gemäß Fig. 1B ist der RFID-Transponder in einem Relais-Bauteil integriert. Gemäß der in Fig. 1C dargestellten Ausführungsform ist der RFID-Transponder in der Tragschiene selbst integriert. Dabei ist der RFID-Transponder in jeder Ausführungsform verliersicher angeordnet. Bei der Integration des RFID-Transponders in die Bauteile (Endhalter, elektrische Geräte wie Relais, Trennverstärker, Reihenklemmen) ist der RFID-Transponder vorzugsweise in den Gehäusen dieser Bauteile angeordnet. Zu diesem Zweck weisen die Gehäuse entsprechende Aussparungen zur verliersicheren Aufnahme des RFID-Transponders auf. Dabei können die RFID-Transponder beispielsweise eingepresst oder eingeklebt sein. Bei Gehäusen aus Kunststoff ist es darüber hinaus auch vorgesehen, die RFID-Transponder bei der Herstellung des Gehäuses beim Kunststoff-Spritzgießen in das Gehäuse einzubetten.

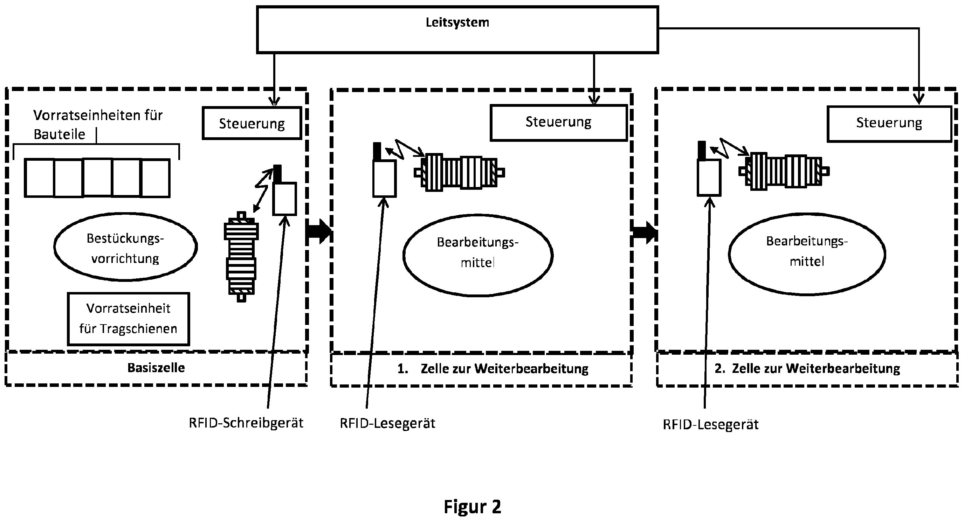

Figur 2 zeigt eine schematische Übersicht über die erfindungsgemäße Anlage bestehend aus einer Basiszelle und zwei nachfolgenden Zellen zur Weiterbearbeitung. Dabei werden die in der Basiszelle mit Bauteilen bestückten Tragschienen in den nachfolgenden Zellen weiteren Bearbeitungsprozessen unterzogen. Die Basiszelle enthält fünf Vorratseinheiten für die Bevorratung der zu bestückenden Bauteile, wobei die erste Vorratseinheit zur Bevorratung von Reihenklemmen, die zweite Vorratseinheit von die Bevorratung von Relais, die dritte Vorratseinheit für die Bevorratung von Trennverstärkern, die vierte Vorratseinheit für die Bevorratung von Endhaltern ohne RFID-Transponder und die fünfte Vorratseinheit für die Bevorratung von Endhaltern mit RFID-Transponder dient.

Darüber hinaus weist die Basiszelle eine Vorratseinheit für die Bevorratung von Tragschienen auf. Innerhalb der Basiszelle erfolgt nun die auftragsindividuelle Bestückung der Tragschienen mit den Bauteilen. Dabei ist auftragsindividuell bestimmt, welche Art von Bauteilen (Reihenklemmen, Relais, Trennverstärker, Endhalter), wie viele Bauteile, von welcher Art und in welcher Reihenfolge diese zu bestücken sind. Dementsprechend werden nacheinander die jeweiligen Bauteile aus den Vorratseinheiten entnommen und sequentiell auf die Tragschiene zur Bestückung aufgerastet. Als letztes Bauteil wird endseitig der Endhalter mit dem RFID-Transponder aufgerastet. Damit ist die Tragschiene gemäß dem individuellen Auftrag vollständig bestückt.

Die Bestückung der Tragschiene mit den Bauteilen kann vollautomatisch, halbautomatisch oder vollständig manuell erfolgen. Bei der vollautomatischen oder halbautomatischen Bestückung weist die Basiszelle eine Bestückungsvorrichtung auf.

Die Basiszelle weist erfindungsgemäß ein Schreibgerät in Form eines RFID-Schreibgerätes auf, welches in einem letzten Bearbeitungsschritt die auftragsindividuellen Daten an den RFID-Transponder der bestückten Tragschiene zur Abspeicherung überträgt. Die auftragsindividuellen Daten empfängt das RFID-Schreibgerät direkt von dem Leitsystem der Anlage oder indirekt über eine lokale Steuerung der Basiszelle, die wiederum mit dem Leitsystem verbunden ist. Dabei kann die Basiszelle auch ein RFID-Lesegerät oder ein kombiniertes RFID-Schreib-/Lesegerät aufweisen. Auf diese Weise können beispielsweise die eingeschriebenen Daten auch zur Kontrolle wiederausgelesen werden.

In nachfolgenden Zellen, in denen die die bestückte Tragschiene weiterbearbeitet wird, werden die auftragsindividuellen Daten dann aus dem RFID-Transponder über ein RFID-Lesegerät ausgelesen. Anhand der ausgelesen, auftragsindividuellen Daten erfolgt dann die weitere Bearbeitung in der jeweiligen Zelle. Auch die Weiterbearbeitungszellen können neben dem RFID-Lesegerät auch ein RFID-Schreibgerät oder ein kombiniertes RFID-Schreib-/Lesegerät aufweisen. Auf diese Weise kann beispielsweise eine Information über die erfolgreiche Weiterbearbeitung in den RFID-Transponder geschrieben werden.

Die auftragsindividuellen Daten können folgende Informationen enthalten:
▪ Anzahl der Bauteile auf der Tragschiene,
▪ Art der Bauteile,
▪ Konfiguration der Bauteile,
▪ Abmessungen der Bauteile,
▪ Bedruckungsdaten für auf die Bauteile nach der Bestückung aufzubringende Beschriftungsschilder,
▪ Bilder der bestückten Tragschienen mit den bedruckten Beschriftungsschildern auf den Bauteilen,
▪ Gesamtbreite der aneinandergereihten Bauteile,
▪ etc.

Anstatt die vorstehend aufgeführten Informationen vollständig in den RFID-Transpondern abzuspeichern, ist es vorteilhafter Weise vorgesehen, als letzten Bearbeitungsschritt in der Basiszelle lediglich eine Auftragsnummer im RFID-Transponder abzuspeichern. Dabei sind in dem Leitsystem der Anlage und/oder in einer lokalen Steuerung einer Weiterbearbeitungszelle Auftragsnummern und die zugehörigen Auftragsinformationen gespeichert. Die aus der Speichereinheit ausgelesene Auftragsnummer wird dann an das Leitsystem und/oder die lokale Steuerung weitergeleitet, um die zugehörigen Auftragsinformationen zu erhalten, die für die Bearbeitung in der Weiterbearbeitungszelle erforderlich sind.

In einer alternativen Ausführungsform wird als letzter Bearbeitungsschritt in der Basiszelle zusätzlich zu den vorstehend genannten Informationen eine Ortskennzeichnung zur Kennzeichnung des Schaltschranks, in den die bestückte Tragschiene einzubauen ist, im RFID-Transponder abgespeichert. Es ist auch vorgesehen als auftragsindividuelle Daten nur die Ortskennzeichnung abzuspeichern.

Der Transport der bestückten Tragschienen von der Basiszelle zur ersten Weiterbearbeitungszelle sowie der Transport zwischen Weiterbearbeitungszellen kann manuell oder automatisch über entsprechende Transportmittel erfolgen. Die Transportmittel sind beispielsweise Rollenbahnen, auf denen die bestückte Tragschiene zum Transport aufliegt, wobei die bestückte Tragschiene mit den RFID-Transponder bis zu einer Leseposition der jeweils nächsten Weiterbearbeitungszelle transportiert wird, wo der RFID-Transponder von dem RFID-Lesegerät ausgelesen werden kann. Dabei ist es für das Auslesen des RFID-Transponders vorteilhaft, wenn dieser in einem Endhalter angeordnet ist, da die Endhalter immer endseitig vorn oder hinten an den bestückten Tragschienen angeordnet sind, so dass hierüber die Position des RFID-Transponders an den bestückten Tragschienen quasi universell festgelegt wird. Somit ist es einfacher, die bestückte Tragschiene in die entsprechende Leseposition zu fahren. Es ist jedoch auch möglich, den RFID-Transponder während des Transports der bestückten Tragschiene an dem Lesegerät vorbei, quasi im Vorbeifahren, auszulesen.

Die auftragsindividuelle Bestückung der Tragschienen führt dazu, dass die Tragschienen bis auf die Endhalter mit unterschiedlichen Bauteilen bestückt sind. So kann es beispielsweise sein, dass eine Tragschiene nur mit Reihenklemmen und eine andere nur mit Trennverstärkern bestückt ist. Endhalter, die in der Regel auch noch baugleich sind, weisen jedoch beide Tragschienen auf. Daher eignen sich Endhalter als quasi universelle Bauteile in besonderer Weise als Träger der RFID-Transponder. Unter Verwendung eines Vorrats an Endhaltern mit integrierten RFID-Transpondern ist es daher möglich, unterschiedlich bestückte Tragschienen auszustatten.

Endhalter als Träger der RFID-Transponder haben darüber hinaus auch den Vorteil, dass bei im Schaltschrank eingebauten bestückten Tragschienen die RFID-Transponder einfacher auszulesen sind, da zum einem auch hier wieder die endseitige Position eindeutig bestimmt ist und zum anderen in der Regel zu beiden Seiten der Endhalter ausreichend Platz zu den Schaltschrankwänden besteht, um ggf. ein mobiles RFID-Lesegerät neben die Endhalter positionieren zu können.

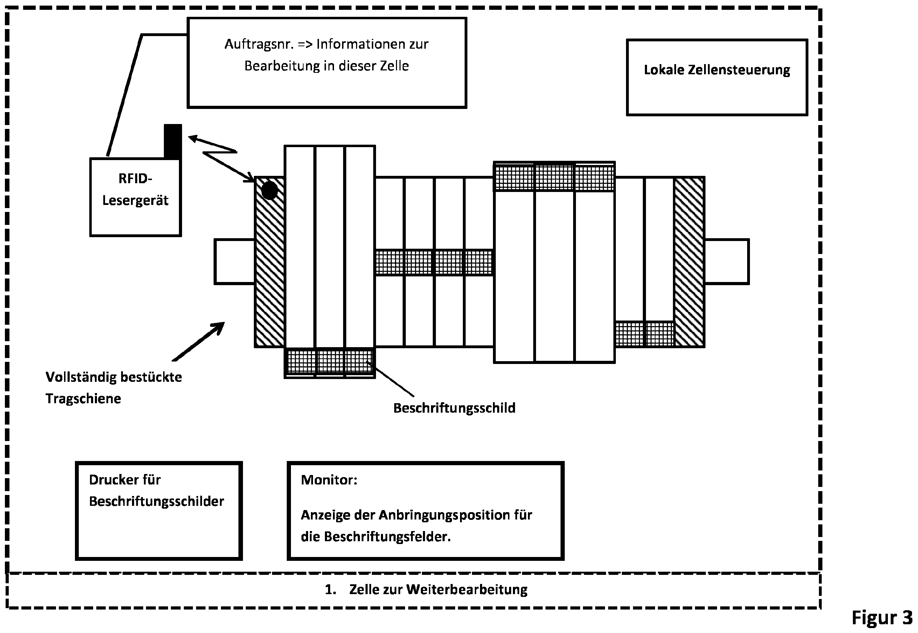

In Figur 3 ist eine erste Weiterbehandlungszelle ausführlicher dargestellt. In dieser Weiterbearbeitungszelle werden auftragsindividuell Beschriftungsschilder für die Bauteile der Tragschiene gedruckt. Das Aufbringen der Beschriftungsschilder kann manuell oder automatisch erfolgen. Anhand der aus dem RFID-Transponder ausgelesenen Auftragsnummer können dann aus dem Leitsystem die Bedruckungsdaten für auf die Bauteile aufzubringende Beschriftungsschilder abgerufen werden und die Beschriftungsschilder mit einem Drucker bedruckt werden. Als Montageassistenz beim manuellen Aufbringen der Beschriftungsschilder wird auf einem Monitor die Anbringungsposition der Beschriftungsfelder angezeigt. Hierfür wird vorzugsweise ein Bild der bestückten Tragschiene mit den bedruckten Beschriftungsschildern auf den Bauteilen als Vorlage angezeigt.

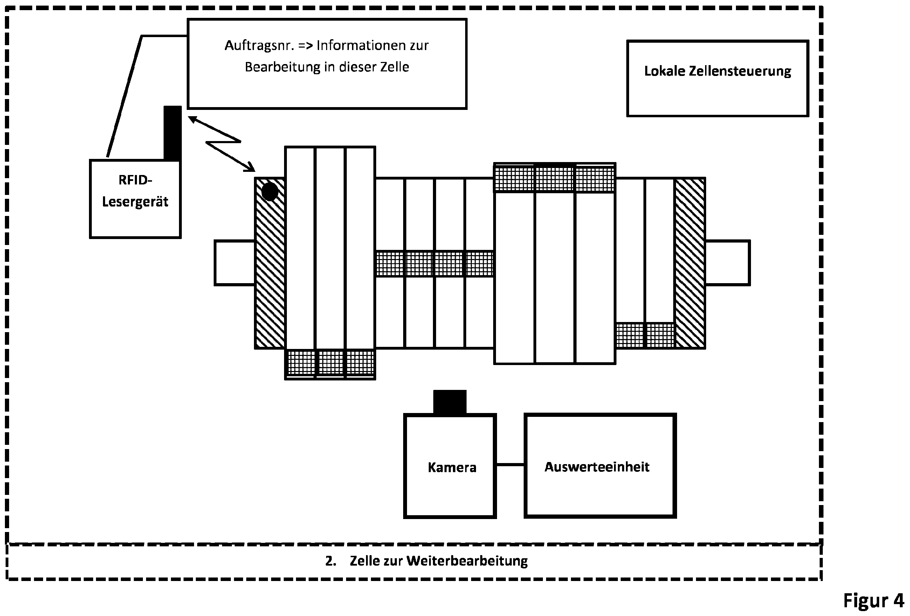

In Figur 4 ist eine weitere, zweite Weiterbehandlungszelle ausführlicher dargestellt. In dieser Weiterbearbeitungszelle erfolgt eine kamerabasierte visuelle Inspektion der auftragsindividuell bestückten und bedruckten Tragschiene. Dabei wird mit einer Kamera eine Bild der bestückten und bedruckten Tragschiene aufgenommen. Mithilfe von digitaler Bildverarbeitung kann dann im Vergleich mit den Auftragsinformationen die ordnungsgemäße Beschriftung, die Gesamtbreite der aneinandergereihten Bauteile und die Vollständigkeit der Bestückung überprüft werden. Die dafür benötigten Auftragsinformationen werden durch das Auslesen der Auftragsnummer aus dem RFID-Transponder ermittelt.

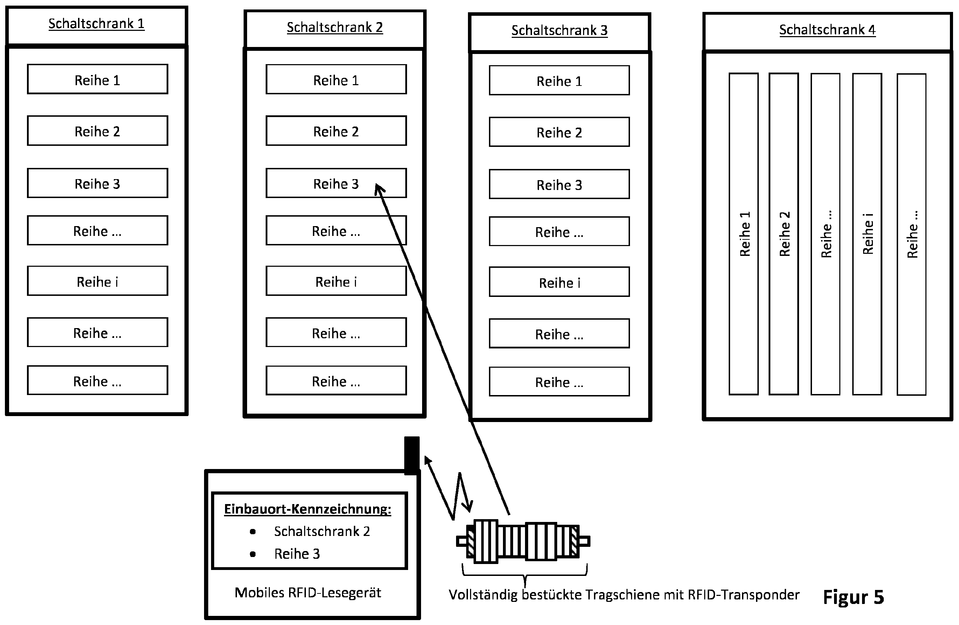

Figur 5 zeigt mehrere Schaltschränke, die jeweils eine Vielzahl von Reihen für mögliche Einbaupositionen für mit Bauteilen bestückte Tragschienen aufweisen. Eine typische Situation für einen Monteur, der bestückte Tragschienen in Schaltschränke einbauen soll. Mithilfe eines mobilen RFID-Lesegerätes kann der Monteur nun in einfacher Weise das Ortskennzeichen aus dem RFID-Transponder der bestückten Tragschiene auslesen. Dabei kann das Ortskennzeichen bestehend aus Schaltschrank-Nr. und Einbaureihe auf einem Display angezeigt werden oder über eine Sprachausgabe dem Monteur mitgeteilt werden. So wird der Monteur einfach und zuverlässig darüber informiert, in welchen Schaltschrank und in welche Reihe innerhalb des Schaltschranks die bestückten Tragschienen jeweils einzubauen sind.

Das Auslesen der RFID-Transponder ist auch dann vorteilhaft, wenn die bestückten Tragschienen bereits im Schaltschrank eingebaut sind. So kann z.B. die richtige Einbauposition einer bestückten Tragschiene überprüft werden. Außerdem ist es so möglich, in einfacher Weise die Auftragsinformationen einer bestückten Tragschiene abzufragen, was den Ersatz einzelner Bauteil auf der Tragschiene oder den vollständigen Austausch der bestückten Tragschiene erleichtert.

## Patentansprüche

1. Anlage zur auftragsindividuellen Bestückung von Tragschienen mit Bauteilen, insbesondere Reihenklemmen, elektrische Geräte oder Endhalter, die für den späteren Einbau in Schaltschränke bestimmt sind, wobei die Anlage mindestens eine Basiszelle aufweist,
- wobei die Basiszelle mindestens eine Vorratseinheit für die Bevorratung der zu bestückenden Bauteile und mindestens eine Vorratseinheit für die Bevorratung von Tragschienen aufweist,
- wobei in der Basiszelle die Bestückung der Tragschiene mit den Bauteilen erfolgt, **dadurch gekennzeichnet, dass**
- die Basiszelle ein Schreibgerät aufweist, das dazu ausgebildet ist, drahtlos Daten jeweils an eine an der mit Bauteilen bestückten Tragschiene angeordnete Speichereinheit mit integrierter drahtloser Kommunikationsschnittstelle zur Abspeicherung zu übertragen,
- die Daten auftragsindividuelle Informationen enthalten.

2. Anlagen nach Anspruch 1, **dadurch gekennzeichnet**, das die Daten mindestens eine Auftragsnummer und/oder eine Ortskennzeichnung zur Kennzeichnung des Schaltschranks, in den die bestückte Tragschiene einzubauen ist, enthalten.

3. Anlage nach Anspruch 2, **dadurch gekennzeichnet, dass** die Daten zur Ortskennzeichnung eine Information zur Einbauposition der bestückten Tragschiene innerhalb des Schaltschranks umfasst.

4. Anlage nach einem der vorstehenden Ansprüche, **dadurch gekennzeichnet, dass** die Basiszelle ein Lesegerät aufweist, das dazu ausgebildet ist, drahtlos Daten jeweils von einer an der mit Bauteilen bestückten Tragschiene angeordneten Speichereinheit auszulesen.

5. Anlage nach Anspruch 4, **dadurch gekennzeichnet, dass** die Basiszelle ein kombiniertes Schreib-/Lesegerät aufweist.

6. Anlage nach einem der vorstehenden Ansprüche, **dadurch gekennzeichnet, dass** die Basiszelle eine Vorrichtung zur automatischen Bestückung der Tragschiene mit Bauteilen aufweist.

7. Anlage nach einem der vorstehenden Ansprüche, **dadurch gekennzeichnet, dass** dieselbe mindestens eine weitere Zelle aufweist, der die vollständig bestückten Tragschienen zur weiteren Bearbeitung zugeführt werden, wobei die weitere Zelle ein Lesegerät zum drahtlosen Auslesen der Speichereinheit aufweist, wobei anhand der ausgelesenen auftragsindividuellen Daten die weitere Bearbeitung der vollständig bestückten Tragschienen in dieser Zelle erfolgt.

8. Anlage nach Anspruch 7, **dadurch gekennzeichnet, dass** in einem Leitsystem der Anlage und/oder in einer lokalen Steuerung der weiteren Zelle Auftragsnummern und zugehörige Auftragsinformationen gespeichert sind, die aus der Speichereinheit an der bestückten Tragschiene ausgelesene Auftragsnummer an das Leitsystem und/oder die lokale Steuerung weitergeleitet wird, um die zugehörigen Auftragsinformationen zu erhalten.

9. Bestückte Tragschiene für den Einbau in Schaltschränke, die auftragsindividuell mit Bauteilen, insbesondere Reihenklemmen, elektrischen Geräten oder Endhaltern bestückt ist unter Verwendung der Anlage zur auftragsindividuellen Bestückung von Tragschienen mit Bauteilen nach einem der Ansprüche 1 bis 8, **dadurch gekennzeichnet, dass** die bestückte Tragschiene eine Speichereinheit mit integrierter drahtloser Kommunikationsschnittstelle aufweist, wobei in der Speichereinheit auftragsindividuelle Daten gespeichert sind.

10. Bestückte Tragschiene nach Anspruch 9, **dadurch gekennzeichnet, dass** in der Speichereinheit Daten betreffend mindestens eine Auftragsnummer und/oder betreffend eine Ortskennzeichnung zur Kennzeichnung des Schaltschranks, in den die bestückte Tragschiene einzubauen ist, gespeichert sind.

11. Bestückte Tragschiene nach Anspruch 10, **dadurch gekennzeichnet, dass** die gespeicherten Daten zur Ortskennzeichnung eine Information zur Einbauposition der bestückten Tragschiene innerhalb des Schaltschranks umfassen.

12. Bestückte Tragschiene nach einem der Ansprüche 9 bis 11, **dadurch gekennzeichnet, dass** die Speichereinheit mit integrierter drahtloser Kommunikationsschnittstelle an oder in mindestens einem der Bauteilen angeordnet ist.

13. Bestückte Tragschiene nach Anspruch 12, **dadurch gekennzeichnet, dass** die Speichereinheit mit integrierter drahtloser Kommunikationsschnittstelle an oder in einem Endhalter angeordnet ist.

14. Bestückte Tragschiene nach einem der Ansprüche 12 oder 13, **dadurch gekennzeichnet, dass** die Speichereinheit mit integrierter drahtloser Kommunikationsschnittstelle im Gehäuse eines Bauteils integriert ist.

15. Bestückte Tragschiene nach einem der Ansprüche 9 bis 11, **dadurch gekennzeichnet, dass** die Speichereinheit mit integrierter drahtloser Kommunikationsschnittstelle an der Tragschiene selbst angeordnet ist.

16. Bestückte Tragschiene nach einem der Ansprüche 9 bis 15, **dadurch gekennzeichnet, dass** die Speichereinheit mit integrierter drahtloser Kommunikationsschnittstelle ein RFID-Transponder ist.

17. Verfahren zur auftragsindividuellen Bestückung von Tragschienen mit Bauteilen, insbesondere Reihenklemmen, elektrische Geräte oder Endhalter, die für den späteren Einbau in Schaltschränke bestimmt sind, aufweisend die folgenden Schritte:
- Bereitstellen eines Vorrats von zu bestückenden Bauteilen,
- Bereitstellen eines Vorrats von Tragschienen,
- vollständige Bestückung der Tragschiene mit den zu bestückenden Bauteilen, **gekennzeichnet durch** die folgenden Schritte:
- mittels eines Schreibgerätes erfolgt ein drahtloses Übertragen von Daten jeweils an eine Speichereinheit mit integrierter drahtloser Kommunikationsschnittstelle, wobei die Speichereinheit an der vollständig mit Bauteilen bestückten Tragschiene angeordnet ist, wobei die Daten auftragsindividuelle Informationen enthalten.

18. Verfahren nach Anspruch 17, **dadurch gekennzeichnet, dass** die Daten mindestens eine Auftragsnummer und/oder eine Ortskennzeichnung zur Kennzeichnung des Schaltschranks, in den die vollständig bestückte Tragschiene einzubauen ist, aufweisen.

## Claims

1. System for fitting supporting rails, in an order-specific manner, with components, in particular terminal blocks, electrical devices or end holders, which are intended for subsequent installation in switchgear cabinets, wherein the system has at least one basic cell,
- wherein the basic cell has at least one supply unit for supplying the components to be fitted and at least one supply unit for supplying supporting rails,
- wherein the supporting rail is fitted with the components in the basic cell,
**characterized in that**
- the basic cell has a writing device which is designed to wirelessly transmit data to a respective storage unit which is arranged on the supporting rail fitted with components and has an integrated wireless communication interface for storage,
- the data contain order-specific information.

2. System according to Claim 1, **characterized in that** the data contain at least one order number and/or a location marking for marking the switchgear cabinet in which the supporting rail fitted with components is to be installed.

3. System according to Claim 2, **characterized in that** the data relating to the location marking comprise an item of information relating to the installation position of the supporting rail fitted with components inside the switchgear cabinet.

4. System according to one of the preceding claims, **characterized in that** the basic cell has a reading device which is designed to wirelessly read data from a respective storage unit arranged on the supporting rail fitted with components.

5. System according to Claim 4, **characterized in that** the basic cell has a combined writing/reading device.

6. System according to one of the preceding claims, **characterized in that** the basic cell has an apparatus for automatically fitting the supporting rail with components.

7. System according to one of the preceding claims, **characterized in that** said system has at least one further cell which is supplied with the supporting rails completely fitted with components for further processing, wherein the further cell has a reading device for wirelessly reading the storage unit, wherein the supporting rails completely fitted with components are processed further in this cell on the basis of the order-specific data which have been read.

8. System according to Claim 7, **characterized in that** order numbers and associated order information are stored in a control system of the system and/or in a local controller of the further cell, and the order number read from the storage unit on the supporting rail fitted with components is forwarded to the control system and/or to the local controller in order to obtain the associated order information.

9. Supporting rail fitted with components for installation in switchgear cabinets, which supporting rail is fitted, in an order-specific manner, with components, in particular terminal blocks, electrical devices or end holders, using the system for fitting supporting rails, in an order-specific manner, with components according to one of Claims 1 to 8, **characterized in that** the supporting rail fitted with components has a storage unit with an integrated wireless communication interface, wherein order-specific data are stored in the storage unit.

10. Supporting rail fitted with components according to Claim 9, **characterized in that** data relating to at least one order number and/or relating to a location marking for marking the switchgear cabinet in which the supporting rail fitted with components is to be installed are stored in the storage unit.

11. Supporting rail fitted with components according to Claim 10, **characterized in that** the stored data relating to the location marking comprise an item of information relating to the installation position of the supporting rail fitted with components inside the switchgear cabinet.

12. Supporting rail fitted with components according to one of Claims 9 to 11, **characterized in that** the storage unit with an integrated wireless communication interface is arranged on or in at least one of the components.

13. Supporting rail fitted with components according to Claim 12, **characterized in that** the storage unit with an integrated wireless communication interface is arranged on or in an end holder.

14. Supporting rail fitted with components according to either of Claims 12 and 13, **characterized in that** the storage unit with an integrated wireless communication interface is integrated in the housing of a component.

15. Supporting rail fitted with components according to one of Claims 9 to 11, **characterized in that** the storage unit with an integrated wireless communication interface is arranged on the supporting rail itself.

16. Supporting rail fitted with components according to one of Claims 9 to 15, **characterized in that** the storage unit with an integrated wireless communication interface is an RFID transponder.

17. Method for fitting supporting rails, in an order-specific manner, with components, in particular terminal blocks, electrical devices or end holders, which are intended for subsequent installation in switchgear cabinets, having the following steps of:
- providing a supply of components to be fitted,
- providing a supply of supporting rails,
- completely fitting the supporting rail with the components to be fitted,
**characterized by** the following steps:
- a writing device is used to wirelessly transmit data to a respective storage unit with an integrated wireless communication interface, wherein the storage unit is arranged on the supporting rail which has been completely fitted with components, wherein the data contain order-specific information.

18. Method according to Claim 17, **characterized in that** the data have at least one order number and/or a location marking for marking the switchgear cabinet in which the supporting rail completely fitted with components is to be installed.

## Revendications

1. Équipement servant à la garniture spécifique à un ordre de rails porteurs avec des composants, notamment des barrettes à bornes, des appareils électriques ou des crampons terminaux, qui sont conçus pour une installation ultérieure dans des armoires électriques, l'équipement possédant au moins une cellule de base,
- la cellule de base possédant au moins une unité de réserve pour la mise en réserve des composants à implanter et au moins une unité de réserve pour la mise en réserve des rails porteurs,
- la garniture du rail porteur avec les composants s'effectuant dans la cellule de base,
**caractérisé en ce que**
- la cellule de base possède un appareil d'écriture qui est configuré pour transmettre sans fil, en vue de leur mémorisation, des données respectivement à une unité de mémoire comprenant une interface de communication sans fil et disposée sur le rail porteur garni de composants,
- les données contiennent des informations spécifiques à un ordre.

2. Équipements selon la revendication 1, **caractérisés en ce que** les données contiennent au moins un numéro d'ordre et/ou un identificateur de lieu destiné à identifier l'armoire électrique dans laquelle doit être installé le rail porteur garni.

3. Équipement selon la revendication 2, **caractérisé en ce que** les données destinées à l'identification de lieu comprennent une information à propos de la position d'installation du rail porteur garni à l'intérieur de l'armoire électrique.

4. Équipement selon l'une des revendications précédentes, **caractérisé en ce que** la cellule de base possède un appareil de lecture qui est configuré pour lire sans fil des données respectivement d'une unité de mémoire disposée sur le rail porteur garni des composants.

5. Équipement selon la revendication 4, **caractérisé en ce que** la cellule de base possède un appareil combiné d'écriture/lecture.

6. Équipement selon l'une des revendications précédentes, **caractérisé en ce que** la cellule de base possède un dispositif destiné à garnir automatiquement le rail porteur avec des composants.

7. Équipement selon l'une des revendications précédentes, **caractérisé en ce que** celui-ci possède au moins une cellule supplémentaire à laquelle sont acheminés les rails porteurs entièrement garnis en vue d'un traitement supplémentaire, la cellule supplémentaire possédant un appareil de lecture destiné à la lecture sans fil de l'unité de mémoire, le traitement supplémentaire des rails porteurs entièrement garnis s'effectuant dans cette cellule à l'aide des données spécifiques à l'ordre lues.

8. Équipement selon la revendication 7, **caractérisé en ce que** des numéros d'ordre et des informations d'ordre associées sont mémorisés dans un système de contrôle de l'équipement et/ou dans une commande locale de la cellule supplémentaire, le numéro d'ordre lu depuis l'unité de mémoire sur le rail porteur garni étant retransmis au système de contrôle et/ou à la commande locale afin d'obtenir les informations de commande associées.

9. Rail porteur garni destiné à l'installation dans des armoires électriques, lequel est garni spécifiquement à un ordre avec des composants, notamment des barrettes à bornes, des appareils électriques ou des crampons terminaux, en utilisant l'équipement servant à la garniture spécifique à un ordre de rails porteurs avec des composants selon l'une des revendications 1 à 8, **caractérisé en ce que** le rail porteur garni possède une unité de mémoire comprenant une interface de communication sans fil intégrée, des données spécifiques à un ordre étant mémorisées dans l'unité de mémoire.

10. Rail porteur garni selon la revendication 9, **caractérisé en ce que** des données concernant au moins un numéro d'ordre et/ou concernant un identificateur de lieu destiné à identifier l'armoire électrique dans laquelle doit être installé le rail porteur garni sont mémorisées dans l'unité de mémoire.

11. Rail porteur garni selon la revendication 10, **caractérisé en ce que** les données destinées à l'identification de lieu comprennent une information à propos de la position d'installation du rail porteur garni à l'intérieur de l'armoire électrique.

12. Rail porteur garni selon l'une des revendications 9 à 11, **caractérisé en ce que** l'unité de mémoire avec l'interface de communication sans fil intégrée est disposée sur ou dans au moins l'un des composants.

13. Rail porteur garni selon la revendication 12, **caractérisé en ce que** l'unité de mémoire avec l'interface de communication sans fil intégrée est disposée sur ou dans un crampon terminal.

14. Rail porteur garni selon l'une des revendications 12 ou 13, **caractérisé en ce que** l'unité de mémoire avec l'interface de communication sans fil intégrée est intégrée dans le boîtier d'un composant.

15. Rail porteur garni selon l'une des revendications 9 à 11, **caractérisé en ce que** l'unité de mémoire avec l'interface de communication sans fil intégrée est disposée sur le rail porteur lui-même.

16. Rail porteur garni selon l'une des revendications 9 à 15, **caractérisé en ce que** l'unité de mémoire avec l'interface de communication sans fil intégrée est un transpondeur RFID.

17. Procédé de garniture spécifique à un ordre de rails porteurs avec des composants, notamment des barrettes à bornes, des appareils électriques ou des crampons terminaux, qui sont conçus pour une installation ultérieure dans des armoires électriques, comprenant les étapes suivantes :
- fourniture d'une réserve de composants à implanter,
- fourniture d'une réserve de rails porteurs,
- garniture complète du rail porteur avec les composants à implanter,
**caractérisé par** les étapes suivantes :
- une transmission sans fil de données respectivement à une unité de mémoire comprenant une interface de communication sans fil s'effectue au moyen d'un appareil d'écriture, l'unité de mémoire étant disposée sur le rail porteur entièrement garni de composants, les données contenant des informations spécifiques à un ordre.

18. Procédé selon la revendication 17, **caractérisé en ce que** les données contiennent au moins un numéro d'ordre et/ou un identificateur de lieu destiné à identifier l'armoire électrique dans laquelle doit être installé le rail porteur entièrement garni.
